# EUROPÄISCHE PATENTSCHRIFT

(11) **EP 0 954 902 B1**
(45) Veröffentlichungstag und Bekanntmachung des Hinweises auf die Patenterteilung: **11.09.2002**
(21) Anmeldenummer: 98902950.9
(22) Anmeldetag: 12.01.1998
(51) Int. Cl.: H03B 5/18, G01S 7/282

(54) **MIKROWELLEN-PULSGENERATOR**
MICROWAVE PULSE GENERATOR
GENERATEUR D'IMPULSIONS HYPERFREQUENCES

(30) Priorität: 23.01.1997 DE 19702261
(43) Veröffentlichungstag der Anmeldung: 10.11.1999
(73) Patentinhaber: VEGA Grieshaber GmbH & Co., D-77709 Wolfach (DE)
(72) Erfinder: FEHRENBACH, Josef, D-77716 Haslach (DE); STORZ, Gregor, D-78713 Schramberg (DE); SCHULTHEISS, Daniel, D-78132 Hornberg (DE)
(74) Vertreter: Patentanwälte Westphal, Mussgnug & Partner
(86) Internationale Anmeldenummer: DE9800081
(87) Internationale Veröffentlichungsnummer: WO98033271

(56) Entgegenhaltungen:
- WO-A-96/07931
- DE-C- 4 401 350
- FR-A- 2 595 830
- DIETZ G ET AL: "A 10-14 GHZ QUENCHABLE MMIC OSCILLATOR" PROCEEDINGS OF THE MICROWAVE AND MILLIMETER WAVE MONOLITHIC CIRCUIT SYMPOSIUM, BOSTON, JUNE 10 -11, 1991, Nr. SYMP. 10, 1.Januar 1991, KUMAR M, Seiten 23-26, XP000236225

## Beschreibung

Die Erfindung betrifft einen Mikrowellen-Pulsgenerator gemäß den Merkmalen des Oberbegriffs des Anspruchs 1.

Derartige Mikrowellen-Pulsgeneratoren werden üblicherweise in Radarsystemen, insbesondere in Pulsradarsystemen, zur genauen Entfernungsmessung verwendet und sind z. B. in WO-A-96/07931, FR-A-2595830 oder GB-A-1450236 beschrieben.

Sie sollten folgenden Anforderungen genügen:
a) Die Pulsdauer des Mikrowellen-Pulses muß im Bereich von einer Nanosekunde liegen, damit mit dem Pulsradar das geforderte hohe Auflösungsvermögen erreicht werden kann.
b) Das Pulsradarverfahren benötigt eine hohe Kohärenz der Mikrowellenpuls-Trägerfrequenz und der Pulsfolgefrequenz. Dazu muß sichergestellt werden, daß ein Oszillator immer mit derselben Anfangsphase anschwingt.
c) Das Verhältnis von Pulsperiode zu Pulsdauer muß groß sein, damit der nächste Mikrowellenpuls erst gesendet wird, wenn die Rücklaufzeit aller Zielechos abgelaufen ist.
d) Die Energie im Mikrowellen-Pulsgenerator muß nach der Pulsdauer möglichst weit abgebaut sein, d.h. der Übergang von der Pulsdauer zur Pulspause muß schnell erfolgen, damit auch sehr kleine Echos erfaßt werden können. Der Dynamikumfang eines Pulsradars beträgt üblicherweise etwa 80 bis 100 dB. Um diesen Wert muß der Mikrowellenimpuls nach möglichst kurzer Zeit abgeklungen sein. Dies erfordert eine geringe Güte des frequenzbestimmenden Resonators.

Übliche durchlaufende Mikrowellen-Oszillatoren eignen sich daher nicht dazu, kohärente Pulsfolgen zu erzeugen. Sie besitzen im allgemeinen Resonanzkreise mit hoher Güte (Q > 100), um eine ausreichende Frequenzstabilität zu erreichen. Dies hat zur Folge, daß sie beim Einschalten mehr als einhundert Perioden benötigen bis sie eingeschwungen und nochmals mehr als einhundert Perioden, bis sie wieder ausgeschwungen sind. Spezielle Mikrowellen-Pulsgeneratoren sind daher üblicherweise aufwendig aufgebaut und erzeugen ein sehr breites Spektrum, aus dem mit Hilfe von Bandpaßfiltern das gewünschte Signal herausgefiltert werden muß. Nachteil eines derartigen Mikrowellen-Pulsgenerators ist jedoch sein sehr schlechter Wirkungsgrad.

Aus der DE 44 01 350 C1 ist beispielsweise ein Verfahren zur Erzeugung von Mikrowellen-Pulsen und eine zugehörige Anordnung mit einer Ladungsspeicherdiode (step recovery diode = SRD) bekannt, das zwar den oben genannten Anforderungen a) bis d) genügt, aber, wie oben beschrieben, einen sehr schlechten Wirkungsgrad aufweist. Die darin beschriebene Anordnung enthält einen Impulsgenerator, dem ein Impuls-Differenzierverstärker nachgeschaltet ist. Ein diesem nachgeschaltetes Anpaßnetzwert überträgt die Impulse auf die in einem Resonator integrierte Ladungsspeicherdiode. Der Resonator besteht aus einem kapazitiven und einem induktiven TEM-Leitungs-stück zusammen mit der Sperrkapazität der Ladungsspeicherdiode. Dadurch wird bereits der Schwerpunkt des entstehenden Spektrums festgelegt. Durch weitere Filterung mittels eines Bandpasses erhält man so einen Mikrowellen-Puls mit der Trägerfrequenz f_{T} und der Pulslänge tₚ.

Aufgabe der vorliegenden Erfindung ist es einen Mikrowellen-Pulsgenerator anzugeben, der mit wenig Bauteileaufwand einen Mikrowellen-Puls mit einer Pulslänge tp im Bereich von einer Nanosekunde erzeugt. Des weiteren soll dessen Wirkungsgrad um mindestens den Faktor 10 höher, als der der bisher bekannten Anordnungen sein.

Diese Aufgabe wird durch einen Mikrowellen-Pulsgenerator mit den Merkmalen des Anspruchs 1 gelöst.

Weiterbildungen der Erfindung sind Gegenstände der Unteransprüche.

Vorteil der Erfindung ist, daß der Schaltungsaufwand durch die Erzeugung von Steuerimpulsen geeigneter Dauer, welche zur Spannungsversorgung eines Mikrowellen-Oszillators oder zum Anlegen an einen Steuereingang eines Halbleiterverstärkers des Mikrowellen-Oszillators bereitgestellt werden, erheblich reduziert werden kann. Dadurch kann auf die Verwendung teurer Ladungsspeicherdioden verzichtet werden.

Der Steuerimpuls im Nanosekundenbereich, welcher die Dauer des eigentlichen Mikrowellen-Pulses bestimmt, kann z. B. durch eine einfache Impulsverkürzungsstufe erzeugt werden.

In einer Weiterbildung kann die Ankopplung von Impulsverkürzungsstufe und Oszillator durch eine Treiberstufe und/oder eine Entkopplungsstufe verbessert werden. Sollte die Impulsverkürzungsstufe derart aufgebaut sein, daß sie ein invertiertes Ausgangssignal erzeugt, so kann dies durch eine invertierende Treiberstufe kompensiert werden. Die Entkopplungsstufe kann vorteilhafterweise durch einen sogenannten "Circular Stub" erfolgen.

Weiterhin ist es von Vorteil, den Oszillator mittels eines Serienresonanzkreises aufzubauen, der z. B. die Gate-Drain-Strecke eines Gallium-Arsenid-FETs als kapazitives Element enthält. Dadurch kann insbesondere der Wirkungsgrad der Anordnung deutlich verbessert werden.

Die Impulsverkürzungsstufe kann vorteilhafterweise besonders einfach mittels zweier Bipolartransistoren aufgebaut werden, deren Basisanschlüsse der Eingangsimpuls zugeführt wird, wobei die Kollektor-Emitter-Strecke des zweiten Transistors parallel zur Basis-Emitter-Strecke des ersten Transistors geschaltet ist und der Eingangsimpuls über ein R-C-Glied dem zweiten Transistor zugeführt wird.

Die Erfindung wird nachfolgend anhand von vier Figuren näher erläutert. Es zeigen:
- Figur 1: ein Blockschaltbild der erfindungsgemäßen Anordnung,
- Figur 2: ein Ausführungsbeispiel für eine Impulsverkürzungsstufe mit nachgeschalteter Treiberstufe,
- Figur 3: ein erstes Ausführungsbeispiel für einen Mikrowellen-Oszillator,
- Figur 4: den zeitlichen Verlauf einer Ausgangsignalfolge, und
- Figur 5: ein zweites Ausführungsbeispiel für einen Mikrowellen-Oszillator.

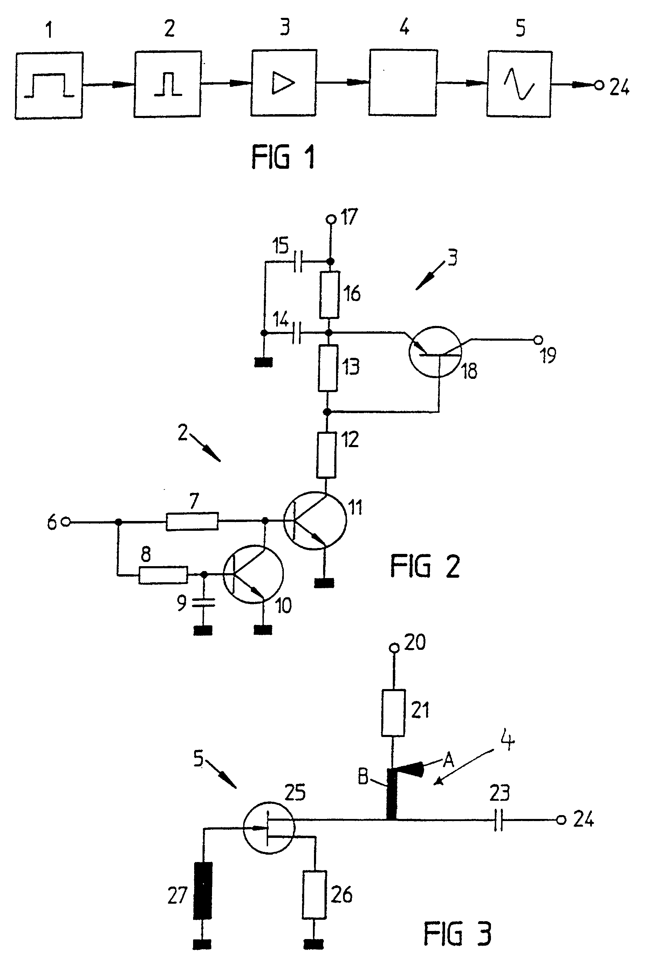

In Figur 1 ist mit 1 ein Impulsgenerator bezeichnet, dessen Ausgangssignal dem Eingang einer Impulsverkürzungsstufe 2 zugeführt wird. Die Impulsverkürzungsstufe 2 erzeugt Ausgangsimpulse im Nanosekundenbereich, die dem Eingang einer Treiberstufe 3 zugeführt werden. Das von der Treiberstufe 3 verstärkte Signal wird einem Entkopplungsnetzwerk 4 zugeführt, welches ausgangseitig mit dem Versorgungsspannungseingang eines Mikrowellen-Oszillators 5 verbunden ist. Das Ausgangsignal des Mikrowellen-Oszillators 5 ist an einer Ausgangsklemme 24 abgreifbar.

Der Impulsgenerator 1 kann in bekannter Weise aufgebaut sein und liefert eine Impulsfolge mit einer vorgegebenen Impulsperiode. Gemäß Figur 2 kann die nachgeschaltete Impulsverkürzungsstufe 2 eine Eingangsklemme 6 aufweisen, welche über einen Widerstand 7 mit der Basis eines npn-Transistors 11 und über einen Widerstand 8 mit der Basis einen npn-Transistors 10 verbunden ist. Zwischen Widerstand 8 und Basis des Transistors 10 ist eine Kapazität 9 gegen Masse geschaltet. Der Kollektor des Transistors 10 ist mit der Basis des Transistors 11 und der Emitter des Transistors 10 mit Masse verbunden. Ebenso ist der Emitter des Transistors 11 mit Masse verschaltet. Der Kollektor des Transistors 11 bildet den Ausgangskreis der Impulsverkürzungsstufe und ist mit dem Eingangskreis der nachgeschalteten Treiberstufe 3 gekoppelt. Hierzu ist der Kollektor über eine Reihenschaltung aus drei Widerständen 12, 13 und 16 mit einer Versorgungsspannungsklemme 17 verbunden. Der Mittelabgriff der Reihenschaltung des Widerstands 12 und 13 ist mit der Basis eines pnp-Transistors 18 verschaltet, der Mittelabgriff der Reihenschaltung aus Widerstand 13 und 16 mit dem Emitter des Transistors 18. Dessen Kollektor ist mit einer Ausgangsklemme 19 verbunden. Der Widerstand 16 ist beidseitig über Entkopplungskapazitäten 14 und 15 mit Masse verbunden.

Ein erfindungsgemäßer Mikrowellen-Oszillator 5 kann folgendermaßen ausgestaltet werden. Gemäß Figur 3 ist eine Versorgungsklemme mit 20 bezeichnet. Diese ist über einen Widerstand 21 mit einem Circular Stub A und einer λ/4-Leitung B verbunden Circular Stub A und λ/4-Leitung B bilden ein Entkopplungsnetzwerk 4. Das andere Ehde der λ/4-Leitung B ist über die Laststrecke eines Transistors 25, hier ein Feldeffekttransistor, und einen dazu in Reihe geschalteten Widerstand 26 mit Masse verbunden. Der Transistor 25 bildet einen Halbleiterverstärker und kann auch ein Bipolartransistor sein. Der Drainanschluß des Feldeffekttransistors 25 ist über eine Kapazität 23 mit der Ausgangsklemme 24 verschaltet. Der Gateanschluß des Feldeffekttransistors 25 ist über eine Induktivität 27 mit Masse verbunden.

Die Ausgangsklemme 19 der Treiberstufe 3 wird mit der Versorgungsklemme 20 verbunden. Der Eingangsklemme 6 wird eine Impulsfolge mit vorgegebener Impulsperiode zugeführt. Der ankommende Impuls des Impulsgenerators 1 wird in der Impulsverkürzungsstufe 2 auf die Länge tₚ verkürzt. Dies geschieht im Ausführungsbeispiel gemäß Figur 2 dadurch, daß die positive Flanke des eingehenden Impulses bei Überschreiten der Basis-Emitter-Spannung des Transistor 11 diesen in den leitenden Zustand überführt. Dadurch wird der Spannungsteiler 12, 13, 16 bestromt, wodurch am Widerstand 13 genug Spannung abfällt, um den Transistor 18 leitend zu schalten. Gleichzeitig wird die positive Flanke des eingehenden Impulses über das RC-Glied 8, 9 um die durch sie definierte Zeit verzögert. Diese Verzögerungszeit läßt sich durch Wahl von schnellen Transistoren von Bruchteilen einer Nanosekunde bis zur Länge des eingehenden Impulses einstellen. Nach Ablauf dieser Verzögerungszeit wird der Transistor 10 leitend geschaltet, so daß die Spannung an der Basis von Transistor 11 auf die Sättigungsspannung von Transistor 10 reduziert wird. Der Transistor 11 kehrt somit wieder in den hochohmigen Zustand zurück und sperrt dadurch auch Transistor 18. An der Ausgangsklemme 19 steht damit ein sehr kurzer Impuls der Länge tₚ zur Verfügung, welcher zudem niederohmig belastbar ist. Durch endliche Anstiegszeiten der Transistoren 10, 11 und 18 besitzt der Ausgangsimpuls eine Kurvenform ähnlich einer sin²-Funktion. Das Netzwerk 14, 15, 16 dient lediglich zur Abblockung der Betriebsspannung, die an der Versorgungsklemme 17 angelegt ist. Die Impulsverkürzungsstufe 2 und Treiberstufe 3 ergänzen sich im vorliegenden Beispiel insofern, da beide Stufen das zu verarbeitende Signal invertieren, wodurch ein nicht invertiertes Signal am Ausgang 19 abgreifbar ist.

Das so gewonnene Signal mit einer Impulsdauer, die der Dauer des Mikrowellen-Pulses entspricht, wird dem Mikrowellen-Oszillator als Versorgungsspannung über die Klemmen 19 und 20 zur Verfügung gestellt. Der Mikrowellen-Oszillator 5 besteht aus einem Transistor 25, der im vorliegenden Beispiel als GalliumArsenid-Feldeffekttransistor ausgeführt ist. Es könnte aber auch ein geeigneter bipolarer Transistor verwendet werden. Des weiteren ist z. B. die Induktivität 27 als induktives TEM-Leitungsstück ausgeführt. Der frequenzbestimmende Resonanzkreis des Mikrowellen-Oszillators 5 wird aus diesem Leitungsstück und der internen Transistorkapazität zwischen Gate und Drain bei FET's, bzw. Basis und Kollektor bei einem Bipolartransistor, gebildet. Dabei bildet das Leitungsstück 27 zusammen mit der Transistorkapazität einen Serienresonanzkreis, der über die Länge des Leitungstückes abgestimmt werden kann. Des weiteren wird dadurch die Phasenbedingung für das Anschwingen erfüllt. Der Widerstand 26 wird zur Reduzierung der Resonanzkreisgüte benötigt, damit ein schnelles Anschwingen gewährleistet ist. Zur Begrenzung des Stroms durch den Transistor 25 ist in der Zuleitung zwischen Treiberstufe 3 und Entkopplungsnetzwerk 4 ein Widerstand 21 eingefügt. Der Kondensator 23 dient zur Abblockung der Versorgungsspannung und koppelt so das Ausgangsignal des Mikrowellen-Oszillators 5 aus.

Der Mikrowellen-Oszillator 5 ist derart ausgestaltet, daß er bei Anlegen einer Versorgungsspannung an der Klemme 20 auf der Resonanzfrequenz des bestimmenden Resonanzkreises ein CW-Signal erzeugt. Bei der Anpassung der Leitungslänge des die Induktivität 27 bildenden Leitungsstücks ist zu beachten, daß der transformierte Anteil der Eigeninduktivität des Widerstandes 26 parallel zur Induktivität 27 berücksichtigt werden muß.

Wie bereits beschrieben, erfolgt die Spannungsversorgung des Mikrowellen-Oszillators 5 durch einen Impuls der Länge tₚ. Dieser wird zur Entkopplung der Impulsverkürzungsstufe und der nachgeschalteten Treiberstufe 3 über das Entkopplungsnetzwerk 4 bestehend aus dem Circular Stub A und der λ/4-Leitung B, dem Mikrowellen-Oszillator 5 an der Versorgungsklemme 20 zugeführt. Die Länge des Impulses bestimmt damit die Länge des Mikrowellenpulses. Der Circular Stub A bildet für die Trägerfrequenz f_{T} einen Kurzschluß, der über eine λ/4-Leitung B in einen Leerlauf transformiert wird. Somit kann keine Hochfrequenz aus dem Mikrowellen-Oszillator 5 in die Treiberstufe 3 gelangen.

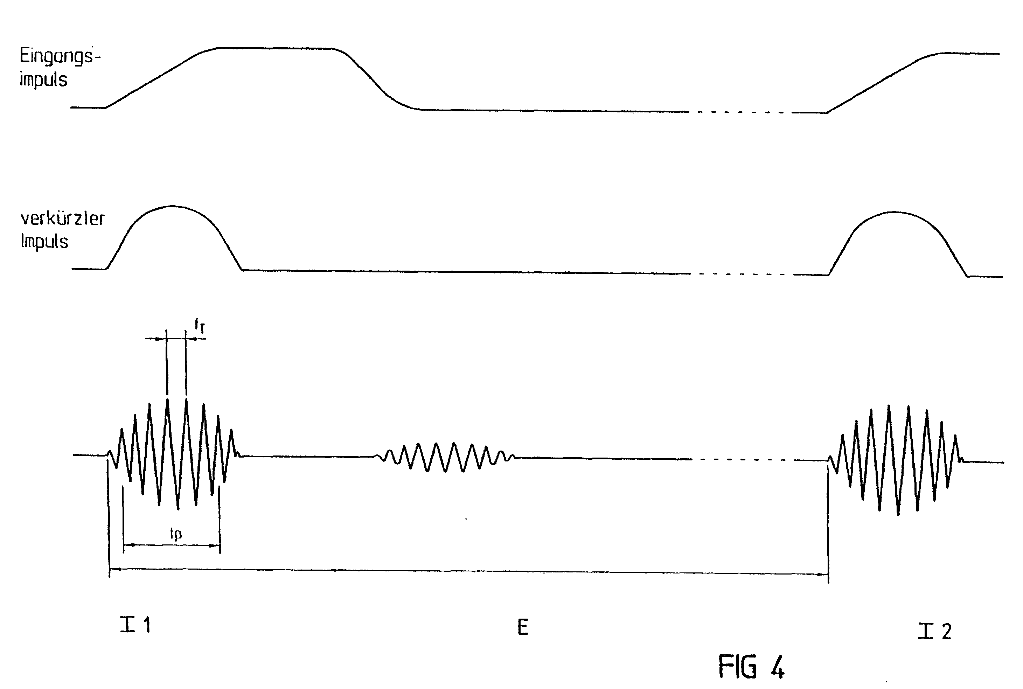

Um ein schnelles Ein- und Ausschwingverhalten zu erreichen, muß der Source-Anschluß über den Widerstand 26 mit Masse verbunden sein. Dieser Widerstand 26 reduziert die Resonanzkreisgüte soweit, daß die Mikrowellenschwingung in ihrer Amplitude der Amplitude des Versorgungsimpulses folgen kann (Fig. 4).

Die Kohärenz der Mikrowellenschwingung wird dadurch erreicht, daß der etwa eine Nanosekunde lange Impuls zur Versorgung des Mikrowellen-Oszillators 5 eine kleine Anstiegzeit besitzt, die im Bereich von etwa 250 ps liegt und damit bereits einen spektralen Energieanteil auf der Resonanzfrequenz in den Mikrowellen-Oszillator 5 einkoppelt. Dadurch ist die Anfangsphase des Mikrowellensignals fest eingeprägt.

An der Ausgangsklemme 24 des Mikrowellen-Oszillators 5 wird der Mikrowellenpuls über die Kapazität 23 ausgekoppelt. Hier ist dem Mikrowellenpuls allerdings noch der verkürzte Impuls überlagert, der jedoch z.B. durch einen Hochpaß weggefiltert werden kann. Wird der entstandene Mikrowellenpuls jedoch in einem Hohlleiter weitergeführt, kann auf den zusätzlichen Hochpaß verzichtet werden, da der Hohlleiter das gleiche Verhalten aufweist.

Figur 4 zeigt den zeitlichen Verlauf zweier aufeinanderfolgender Mikrowellenpulse I1 und I2. Zusätzlich ist zwischen beiden Pulsen I1 und I2 ein Echo E dargestellt, welches z.B. zur Entfernungsmessung ausgewertet wird. Die Oszillationsperiode ist mit f_{T} und die Pulsdauer mit tₚ bezeichnet.

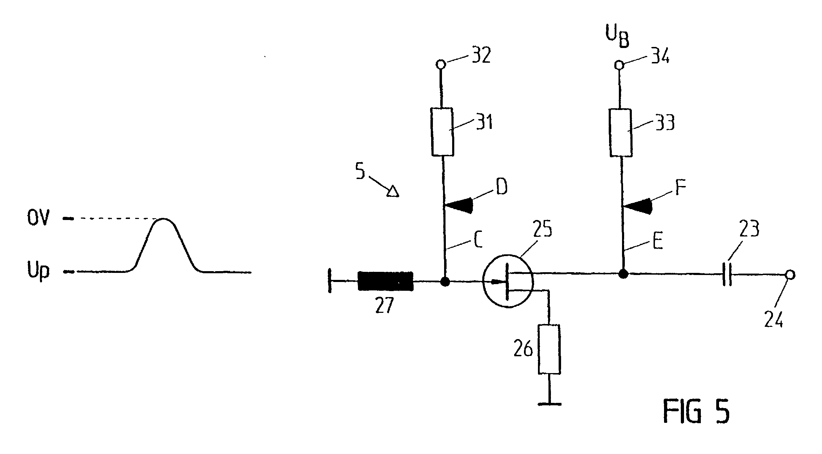

In Fig. 5 ist ein zweites Ausführungsbeispiel für einen Mikrowellen-Oszillator 5 dargestellt. Der Impuls aus der Impulsverkürzungstufe 2 wird bei diesem Ausführungsbeispiel dem Mikrowellen-Oszillator 5 über eine Steuerrelektrode des Halbleiterverstärkers 25 im Gegensatz zur impulsförmig applizierten Betriebsspannungsversorgung des Mikrowellen-Oszillators gemäß Fig. 3 zugeführt. Der Mikrowellen-Oszillator 5 weist wieder einen Transistor 25 auf, der als Gallium-Arsenid-Feldeffekttransistor (kurz GaAs-FET) ausgeführt sein kann. Am Gate des GaAs-FET's 25 ist wieder ein induktives TEM-Leitungsstück zur Bildung einer Induktivität 27 angeschlossen (z. B. eine offene Mikrostreifenleitung mit einer Länge λ/4 und λ/2). Außerdem ist am Gate des GaAs-FET's 25 der Ausgang eines Entkopplungsnetzwerkes, bestehend aus einer λ/4-Leitung C und einem Circular Stub D angeschlossen. Der Eingang dieses Entkopplungsnetzwerkes ist über einen Widerstand 31 mit einer Eingangsklemme 32 des Mikrowellen-Oszillators 5 verbunden. Der Drainanschluß des GaAs-FET's 25 ist in ähnlicher Weise über ein Entkopplungsnetzwerk, bestehend aus einer λ/4-Leitung E und einem Circular Stub F, und einen Widerstand 33 an die Versorgungsklemme 34 angeschlossen. An dieser Versorgungsklemme 34 ist eine Konstante Versorgungsspannung U_{B} anlegbar. Darüber hinaus wird am Drainanschluß des GaAs-FET's 25 das Mikrowellensignal über einen Koppelkondensator 23 an die Ausgangsklemme 24 ausgekoppelt. Der Source-Anschluß des GaAs-FET's 25 liegt über einen Widerstand 26 auf Masse.

Die Funktion dieses Mikrowellen-Oszillators 5 ist folgende, wenn angenommen wird, daß die Form des Steuerimpulses den in Fig. 5 links dargestellten Verlauf hat, also eine Kurvenform ähnlich einer sin²-Funktion, deren Maximum bei 0 Volt liegt und von dem Potential Uₚ ausgeht bzw. auf dieses Potential Uₚ wieder absinkt. Solange am Steuereingang des Mikrowellen-Oszillators 5, also an der Eingangsklemme 32, eine negative Spannung anliegt, die betragsmäßig größer als die pinch-off-Spannung Uₚ ist, bleibt der GaAs-FET 25 im gesperrten Zustand. Steigt an der Eingangsklemme 32 durch den Impuls die Spannung auf 0 Volt, so schwingt der Mikrowellen-Oszillator 5 auf der Resonanzfrequenz des Serienresonanzkreises, der aus dem induktiven TEM-Leitungsstück 27 und der internen Transistorkapazität zwischen Drain und Gate gebildet wird. Eine Frequenzabstimmung ist über die Leitungslänge am Gate möglich. Die notwendige Phasendrehung für die Schwingbedingung wird hiermit ebenfalls beeinflußt. Der Widerstand 26 begrenzt die Güte des Schwingkreises, so daß ein schnelles Ein- und Ausschwingen des Mikrowellen-Oszillators möglich ist.

Im Pulsbetrieb wechselt der Pegel am Steuereingang, also an der Eingangsklemme 32, zwischen 0 Volt und einer negativen Spannung. Durch die geringe Güte des Resonanzkreises ist die Form der Hüllkurve der Mikrowellenschwingung gleich der Form des Steuerimpulses. Die Kohärenz der Mikrowellenschwingungen wird dadurch erreicht, daß die steile Flanke des Steuerimpulses bereits einen spektralen Energieanteil in den Mikrowellen-Oszillator 5 einprägt. Die Anfangsphase ist somit immer gleich. An der Ausgangsklemme 24 des Mikrowellen-Oszillators 5 wird durch die Ansteuerung mit einem kurzen, steil flankigen Steuerimpuls ein im wesentlichen ebenso kurzer sowie phasenstarrer Mikrowellen-Puls ausgegeben. Vorteilhafterweise erfolgt dies mit einem um eine Größenordnung höherem Wirkungsgrad gegenüber derzeit bekannten Mikrowellen-Pulsgeneratoren.

### Bezugszeichenliste

- 1: Impulsgenerator
- 2: Impulsverkürzungsstufe
- 3: Treiberstufe
- 4: Entkopplungsnetzwerk
- 5: Mikrowellen-Oszillator
- 6: Eingangsklemme
- 7: Widerstand
- 8: Widerstand
- 9: Kapazität
- 10: Transistor
- 11: Transistor
- 12: Widerstand
- 13: Widerstand
- 14: Entkopplungskapazität
- 15: Entkopplungskapazität
- 16: Widerstand
- 17: Versorgungsspannungsklemme
- 18: Transistor
- 19: Ausgangsklemme
- 20: Versorgungsklemme
- 21: Widerstand
- 23: Kapazität
- 24: Ausgangsklemme
- 25: Transistor, Halbleiterverstärker
- 26: Widerstand
- 27: Induktivität
- 31: Widerstand
- 32: Eingangsklemme
- 33: Widerstand
- 34: Versorgungsklemme
- A: circular stub
- D: circular stub
- F: circular stub
- B: λ/4-Leitung
- C: λ/4-Leitung
- E: λ/4-Leitung
- U_{B}: Versorgungsspannung

## Patentansprüche

1. Mikrowellen-Pulsgenerator zur Erzeugung von Mikrowellen-Pulsen, die eine Pulsdauer im Nano-Sekundenbereich aufweisen, mit einem Impulsgenerator (2) zur Erzeugung von Steuerimpulsen und mit einem Mikrowellen-Oszillator (5) zur Erzeugung von Mikrowellen-Schwingungen, wobei der Mikrowellen-Oszillator (5) einen aktiven Halbleiterverstärker mit einem frequenzbestimmenden Resonanzkreis aufweist,
**dadurch gekennzeichnet, dass** der Halbleiterverstärker einen Transistor (25), einen Ohm'schen Widerstand (26) und eine Induktivität (27) aufweist, wobei der Ohm'sche Widerstand (26) zwischen Bezugspotential und Source/Emitter-Anschluss der Transistors (25) und die Induktivität (27) zwischen Gate/Basis-Anschluss des Transistors (25) und Bezugspotential geschaltet ist und wobei der Ohm'sche Widerstand (26) zur Reduzierung der Resonanzkreisgüte des Resonanzkreises dient, soweit, dass ein dem Transistor (25) am Gate/Basis-Anschluss oder Drain/Kollektor-Anschluss zugeführter Steuerimpuls an einem Ausgang (24), welcher kapazitiv mit dem Drain/Kollektor-Anschluss des Transistors (25) in Verbindung steht, des Mikrowellen-Oszillators (5) zu einer abgreifbaren Mikrowellen-Schwingung führt, die dem Verlauf des Steuerimpulses mindestens annähernd folgt.

2. Mikrowellen-Pulsgenerator nach Anspruch 1,
**dadurch gekennzeichnet, daß** die Induktivität (27) als induktives TEM-Leitungsstück ausgebildet ist.

3. Mikrowellen-Pulsgenerator nach Anspruch 1 oder 2,
**dadurch gekennzeichnet, daß** eine Eingangsklemme (20; 32) für den Steuerimpuls an den Steuereingang des Halbleiterverstärkers (25) oder an einen Ausgang des Halbleiterverstärkers (25) gekoppelt ist.

4. Mikrowellen-Pulsgenerator nach einem der Ansprüche 1 bis 3, **dadurch gekennzeichnet, daß** zwischen Impulsgenerator (2) und Mikrowellen-Oszillator (5) eine Treiberstufe (3) geschaltet ist.

5. Mikrowellen-Pulsgenerator nach einem der Ansprüche 1 bis 4, **dadurch gekennzeichnet, daß** zwischen Impulsgenerator (2) und Mikrowellen-Oszillator (5) eine Entkopplungsstufe (4) geschaltet ist.

6. Mikrowellen-Pulsgenerator nach Anspruch 5,
**dadurch gekennzeichnet, daß** die Entkopplungsstufe (4) einen Circular Stub (A) enthält.

7. Mikrowellen-Pulsgenerator nach einem der Ansprüche 1 bis 6,
**dadurch gekennzeichnet, daß** der Transistor (25) ein Gallium-Arsenid-Feldeffekttransitor oder Bipolartransistor ist.

8. Mikrowellen-Pulsgenerator nach einem der vorhergehenden Ansprüche,
**dadurch gekennzeichnet, daß** der Impulsgenerator (2)
- einen ersten Transistor (11) aufweist, dessen Steueranschluß die Impulse konstanter Impulsbreite zugeführt werden, und über dessen Laststrecke die Ausgangsimpulse ausgekoppelt werden,
- einen zweiten Transistor (10) aufweist, dessen Laststrecke zwischen dem Steueranschluß des ersten Transistors (11) und Bezugspotential geschaltet ist, und dessen Steueranschluß unter Zwischenschaltung eines Verzögerungsglieds (8, 9) mit dem Impulsen konstanter Impulsbreite beaufschlagt wird.

9. Mikrowellen-Pulsgenerator nach Anspruch 8,
**dadurch gekennzeichnet, daß** die Laststrecke des ersten Transistors (11) einerseits mit dem Bezugspotential verschaltet ist und andererseits über einen Widerstandsteiler (12, 13) mit einer Versorgungsspannungsklemme (17) verbunden ist, und einem der Widerstände (13) des Widerstandsteilers (12, 13) die Emitter-Basis-Strecke eines dritten Transistors (18) parallel geschaltet ist und die Ausgangsimpulse am Kollektor des dritten Transistors (18) abgreifbar sind.

## Claims

1. Microwave pulse generator for the generation of microwave pulses, which have a pulse duration in the nanosecond range, with a pulse generator (2) for the generation of control pulses and with a microwave oscillator (5) for the generation of microwave oscillations, the microwave oscillator (5) having an active semiconductor amplifier with a resonant circuit determining the frequency, **characterised in that** the semiconductor amplifier has a transistor (25), an ohmic resistor (26) and an inductor (27), the ohmic resistor (26) being connected between reference potential and source/emitter connection of the transistor (25) and the inductor (27) between gate/base connection of the transistor (25) and reference potential and the ohmic resistor (26) serving to reduce the Q-factor of the resonant circuit to such an extent that a control pulse fed to the transistor (25) on the gate/base connection or on the drain/collector connection leads to a microwave oscillation, which follows the characteristic of the control pulse at least approximately and which can be tapped off at an output (24), which is capacitatively connected to the drain/collector connection of the transistor (25).

2. Microwave pulse generator according to Claim 1, **characterised in that** the inductor (27) is designed as an inductive section of TEM conductor.

3. Microwave pulse generator according to Claim 1 or 2, **characterised in that** an input terminal (20, 32) for the control pulse is coupled to the control input of the semiconductor amplifier (25) or to an output of the semiconductor amplifier (25).

4. Microwave pulse generator according to one of Claims 1 to 3, **characterised in that** a driver stage (3) is connected between pulse generator (2) and microwave oscillator (5).

5. Microwave pulse generator according to one of Claims 1 to 4, **characterised in that** a decoupling stage (4) is connected between pulse generator (2) and microwave oscillator (5).

6. Microwave pulse generator according to Claim 5, **characterised in that** the decoupling stage (4) contains a circular stub (A).

7. Microwave pulse generator according to one of Claims 1 to 6, **characterised in that** the transistor (25) is a gallium arsenide field-effect transistor or a bipolar transistor.

8. Microwave pulse generator according to one of the preceding claims, **characterised in that** the pulse generator (2)
- has a first transistor (11), to the control connection of which the pulses of constant pulse width are fed and via the load path of which the output pulses are taken off,
- has a second transistor (10), the load path of which is connected between the control connection of the first transistor (11) and reference potential and the control connection of which has the pulses of constant pulse width applied to it, with a delay element (8, 9) being connected in between.

9. Microwave pulse generator according to Claim 8, **characterised in that** the load path of the first transistor (11) is connected, on the one hand, to the reference potential and, on the other, via a resistance divider (12, 13) to a supply voltage terminal (17) and the emitter-base path of a third transistor (18) is connected in parallel with one of the resistors (13) of the resistance divider (12, 13) and the output pulses can be tapped off at the collector of the third transistor (18).

## Revendications

1. Générateur d'impulsions hyperfréquence pour générer des impulsions hyperfréquence ayant une durée d'impulsion de l'ordre de la nanoseconde, comprenant un générateur d'impulsions (2) pour générer des impulsions de commande et un oscillateur hyperfréquence (5) générant des oscillations hyperfréquence, l'oscillateur hyperfréquence (5) comportant un amplificateur semi-conducteur actif avec un circuit de résonance déterminant la fréquence,
**caractérisé en ce que**
l'amplificateur semi-conducteur comprend un transistor (25), une résistance ohmique (26) et une inductance (27),
la résistance ohmique (26) étant branchée entre un potentiel de référence et la jonction source-émetteur du transistor (25), et l'inductance (27) étant branchée entre la jonction porte/base du transistor (25) et un potentiel de référence,
la résistance ohmique (26) servant à réduire la qualité de résonance du circuit résonant dans la mesure où une impulsion de commande appliquée au transistor (25) à la jonction porte/base ou à la jonction drain/collecteur, donne à une sortie (24) branchée de manière capacitive à la jonction drain/collecteur du transistor (25) de l'oscillateur hyperfréquence (5), une oscillation hyperfréquence que l'on peut détecter et qui suit au moins sensiblement la courbe de l'impulsion de commande.

2. Générateur d'impulsions hyperfréquence selon la revendication 1,
**caractérisé en ce que**
l'inductance (27) est un élément de conduite en mode TEM, inductif.

3. Générateur d'impulsions hyperfréquence selon l'une quelconque des revendications 1 ou 2,
**caractérisé par**
une borne d'entrée (20 ; 32) pour l'impulsion de commande, reliée à l'entrée de commande de l'amplificateur semi-conducteur (25) ou à une sortie de cet amplificateur semi-conducteur (25).

4. Générateur d'impulsions hyperfréquence selon l'une quelconque des revendications 1 à 3,
**caractérisé par**
un étage pilote (3) branché entre le générateur d'impulsions (2) et l'oscillateur hyperfréquence (5).

5. Générateur d'impulsions hyperfréquence selon l'une quelconque des revendications 1 à 4,
**caractérisé par**
un étage de découplage (4) entre le générateur d'impulsions (2) et l'oscillateur hyperfréquence (5).

6. Générateur d'impulsions hyperfréquence selon la revendication 5,
**caractérisé en ce que**
l'étage de découplage (4) est un embout circulaire (A).

7. Générateur d'impulsions hyperfréquence selon l'une quelconque des revendications 1 à 6,
**caractérisé en ce que**
le transistor (25) est un transistor à effet de champ à arséniure de gallium ou un transistor bipolaire.

8. Générateur d'impulsions hyperfréquence selon l'une quelconque des revendications précédentes,
**caractérisé en ce que**
le générateur d'impulsions (2) comprend :
- un premier transistor (11) dont la borne de commande reçoit des impulsions de largeur constante et dont le chemin de charge assure le découplage des impulsions de sortie,
- un second transistor (10) dont le chemin de charge est branché entre la borne de commande du premier transistor (11) et un potentiel de référence et dont la borne de commande reçoit des impulsions de largeur constante par l'intermédiaire d'un élément de temporisation (8, 9).

9. Générateur d'impulsions hyperfréquence selon la revendication 8,
**caractérisé en ce que**
le chemin de charge du premier transistor (11) est, d'une part, relié au potentiel de référence, et, d'autre part, à une borne de tension d'alimentation (17) par un diviseur à résistances (12, 13), l'une des résistances (13) du diviseur à résistances (12, 13), étant branchée en parallèle sur le chemin émetteur-base d'un troisième transistor (18) et les impulsions de sortie sont fournies par le collecteur du troisième transistor (18).
